# EUROPÄISCHE PATENTSCHRIFT

(11) **EP 1 950 576 B1**
(45) Veröffentlichungstag und Bekanntmachung des Hinweises auf die Patenterteilung: **17.03.2010**
(21) Anmeldenummer: 07001470.9
(22) Anmeldetag: 24.01.2007
(51) Int. Cl.: G01R 31/28, H05K 13/02

(54) **Führungsvorrichtung und Testvorrichtung für elektronische Bauelemente**
Guiding device and testing device for electronic assembly parts
Dispositif de commande et dispositif de test pour composants électroniques

(43) Veröffentlichungstag der Anmeldung: 30.07.2008
(73) Patentinhaber: Rasco GmbH, 83059 Kolbermoor (DE)
(72) Erfinder: Waldauf, Alexander, 83059 Kolbermoor (DE); Langer, Alfred, 83059 Kolbermoor (DE)
(74) Vertreter: Grünecker, Kinkeldey, Stockmair & Schwanhäusser Anwaltssozietät

(56) Entgegenhaltungen:
- EP-A- 0 291 144
- DE-C- 19 708 291
- US-A- 4 579 527
- US-B1- 6 251 835

## Beschreibung

### Gebiet der Erfindung

Die Erfindung betrifft eine Führungsvorrichtung, welche eine Grundplatteneinrichtung mit einem darin ausgebildeten Führungskanal zur Führung von elektronischen Bauelementen umfasst, und worin wenigstens zwei Abschnitte der Grundplatteneinrichtung räumlich fixiert sind. Die Erfindung betrifft weiterhin eine Testvorrichtung für elektronische Bauelemente.

### Stand der Technik

Für das Testen von elektronischen Bauelementen, wie zum Beispiel integrierten Schaltungen, bei verschiedenen Temperaturen werden Testvorrichtungen verwendet, in denen die elektronischen Bauelemente kurzzeitig erhitzt oder abgekühlt werden.

Um einen hohen Durchsatz von zu testenden elektronischen Bauelementen zu erzielen, werden Führungen eingesetzt welche eine Grundplatte mit einem Führungskanal umfassen. Die Führungsvorrichtung ist dabei vorzugsweise senkrecht angeordnet, sodass die elektronischen Bauelemente durch eine Beschickungsvorrichtung in den Führungskanal eingebracht werden können und durch die auf sie wirkende Schwerkraft im Führungskanal bis zu der Stelle fallen, an der sie temperiert werden. An dieser Stelle ist ein Stopper vorgesehen, die in den Führungskanal geschoben werden können, um die elektronischen Bauelemente zu stoppen.

Aus dem Dokument DE19708291C2 ist eine Führung für elektronische Bauelemente bekannt. Diese Führung weist eine Grundplatte mit einem Führungskanal und Führungsteilen auf.

Die Temperierung kann z.B. in einer Temperaturkammer erfolgen, beispielsweise durch kaltes oder heißes Gas, insbesondere Stickstoff oder Luft, im Temperaturbereich ca. - 50° C und + 150° C. Danach treten sie in eine Entladevorrichtung ein, die beispielsweise die elektronischen Bauelemente sortieren kann, je nach dem ob sie die Tests bestanden haben oder nicht.

### Beschreibung der Erfindung

Wenn die elektronischen Bauteile z.B. auch bei Umgebungstemperatur getestet werden sollen, kann sich beispielsweise oberhalb der Temperaturkammer eine weiter Teststelle befinden. Nach abgeschlossenem Test an dieser Stelle können die elektronischen Bauelemente im weiteren Verlauf der Führung in die Temperierungskammer eintreten worin sich eine zweite Teststelle zum Testen der elektronischen Bauelemente bei hohen oder niedrigen Temperaturen befindet. In diesem Fall muss die Führung an den zwei Teststellen räumlich fixiert, um präzise Tests durchzuführen.

Die aus dem Stand der Technik bekannte Führung ist jedoch dahingehend nachteilig, dass Temperaturänderungen der Grundplatte und der Führungsteile zu Spannungen führen, wenn die Grundplatte an zwei Stellen räumlich fixiert ist. Dies ist bei der oben beschriebenen Testvorrichtung an den Stellen der Fall, an denen die Temperierung und das Testen der elektronischen Bauelemente erfolgt.

Der Erfindung liegt das Problem zugrunde, das Auftreten von Spannungen durch die Ausdehnung bzw. das Zusammenziehen der Materialien der Führung bei unterschiedlichen Temperaturen zu vermeiden.

Das zuvor genannte Problem wird gelöst durch eine erfindungsgemäße Führungsvorrichtung welche eine Grundplatteneinrichtung mit einem darin ausgebildeten Führungskanal zur Führung von elektronischen Bauelementen umfasst, worin wenigstens zwei Abschnitte der Grundplatteneinrichtung räumlich fixiert sind und sich dadurch auszeichnet, dass Mittel zur Kompensation von Wärmedehnung der Grundplatteneinrichtung vorgesehen sind.

Die erfindungsgemäße Führungsvorrichtung hat den Vorteil, das die vorgesehenen Mittel die Wärmeausdehnung der Grundplatteneinrichtung kompensieren, so dass das Auftreten von Spannungen in der Grundplatteneinrichtung, die beispielsweise zu einer Verbiegung des Führungskanals führen können, vermieden wird.

Weiterbildungen der erfindungsgemäßen Führungsvorrichtung werden nachfolgend beschrieben.

Eine Weiterbildung der erfindungsgemäßen Führungsvorrichtung besteht darin, dass die Mittel zur Kompensation von Wärmedehnung der Grundplatteneinrichtung einen Kompensationsbereich der Grundplatteneinrichtung umfassen können. Auf diese Weise können die Mittel zur Kompensation von Wärmedehnung der Grundplatteneinrichtung auf einen Kompensationsbereich der Grundplatteneinrichtung beschränkt bleiben.

Eine Weiterbildung der zuvor genannten Weiterbildung besteht darin, dass die Grundplatteneinrichtung in Führungskanalrichtung eine erste und eine zweite Teilgrundplatte umfasst, zwischen denen im Kompensationsbereich der Grundplatteneinrichtung eine Dehnungslücke ausgebildet ist. Auf diese Weise wird ein einfaches Mittel zur Kompensation der Wärmedehnung der Grundplatteneinrichtung zur Verfügung gestellt.

Eine Weiterbildung der zuvor genannten Weiterbildung besteht darin, dass die erste Teilgrundplatte einen Vorsprung und die zweite Teilgrundplatte eine Aussparung aufweisen kann, derart ausgebildet, dass der Vorsprung und die Aussparung in Führungskanalrichtung gegeneinander bewegbar ineinander greifen und der Vorsprung die Dehnungslücke zur Führung der elektronischen Bauelemente überbrückt. Diese Weiterbildung hat den Vorteil, dass elektronische Bauelemente, die durch den Führungskanal laufen, nicht an der Dehnungslücke verkanten und hängen bleiben.

Eine Weiterbildung der beiden zuletzt genannten Weiterbildungen besteht darin, dass eine der Teilgrundplatten einen Zapfen und die andere Teilgrundplatte eine Ausnehmung zur Aufnahme des Zapfens umfassen kann, worin der Zapfen und die Ausnehmung in einem Querschnitt senkrecht zur Führungskanalrichtung komplementär zueinander ausgebildet sind und der Zapfen relativ zu der Ausnehmung in Führungskanalrichtung bewegbar ist. Auf diese Weise wird eine stabile Verbindung der beiden Teilgrundplatten quer zur Führungskanalrichtung erzielt, wobei jedoch die Bewegbarkeit in Führungskanalrichtung bestehen bleibt.

Eine andere Weiterbildung der erfindungsgemäßen Führungsvorrichtung und deren Weiterbildungen besteht darin, dass eine Führungsschieneneinrichtung entlang des Führungskanals zur wenigstens teilweisen Überdeckung des Führungskanals vorgesehen ist. Dies hat den Vorteil, dass bei im Wesentlichen senkrechter Anordnung der Führungsvorrichtung auch eine Führung der elektronischen Bauelemente von einer offenen Seite des Führungskanals her erfolgt. Dadurch können die elektronischen Bauelemente sicher und stabil im Führungskanal geführt werden ohne die Gefahr, den Führungskanal zu verlassen. Die Führungsschieneneinrichtung kann dabei so angeordnet sein, dass sie den Führungskanal in Längsrichtung lediglich teilweise überdeckt, und insbesondere an dessen Endabschnitten den Führungskanal nicht überdeckt.

Eine andere Weiterbildung der zuvor genannten Weiterbildung besteht darin, dass Abschnitte der Führungsschieneneinrichtung, vorzugsweise in Führungskanalrichtung gelegene Endabschnitte der Führungsschieneneinrichtung, räumlich fixiert sind und Mittel zur Kompensation von Wärmedehnung der wenigstens einen Führungsschieneneinrichtung vorgesehen sein können. Auf diese Weise können auch Längendilatationen bzw. Längenkontraktionen der Führungsschieneneinrichtung unter Wärmeeinwirkung kompensiert werden.

Eine andere Weiterbildung der vorletzten Weiterbildung besteht darin, dass wenigstens zwei Bereiche der Führungsschieneneinrichtung mit der Grundplatteneinrichtung verbunden sind und die Führungseinrichtung Mittel zur Kompensation von Wärmedehnung der Grundplatteneinrichtung und/oder zur Kompensation von Wärmedehnung der Führungsschieneneinrichtung umfassen kann. Auf diese Weise können Spannungen in der Führungsschieneneinrichtung vermieden werden, die ansonsten durch eine Wärmeausdehnung der Grundplatteneinrichtung und/oder der Führungsschieneneinrichtung auftreten könnten.

Eine andere Weiterbildung besteht darin, dass die Führungsschieneneinrichtung wenigstens eine Führungsschiene umfassen kann und wenigstens zwei Bereiche der oder jeder Führungsschiene mit der Grundplatteneinrichtung verbunden sind. Somit wird eine einfache Ausgestaltung der Führungsschieneneinrichtung zur Verfügung gestellt.

Eine andere Weiterbildung besteht darin, dass die Führungsschieneneinrichtung eine erste und eine zweite Führungsschiene umfassen kann, die jeweils derart entlang des Führungskanals angeordnet sind, dass der Führungskanal in Querschnitt beidseitig wenigstens teilweise überdeckt ist. Durch die Verwendung von zwei Führungsschienen, die jeweils von einer Seite des Führungskanals diesen teilweise überdecken, können diese Führungsschienen auf verschiedenen Grundplatteneinrichtungen verwendet werden, wenn beispielsweise für unterschiedliche Größen der elektronischen Bauelemente die Grundplatteneinrichtung durch eine andere mit einem beispielsweise breiteren Führungskanals ausgetauscht wird.

Eine andere Weiterbildung besteht darin, dass die Mittel zur Kompensation von Wärmedehnung der wenigstens einen Führungsschiene und/oder zur Kompensation von Wärmedehnung der Grundplatteneinrichtung einen Kompensationsbereich der Führungsschieneneinrichtung umfassen kann. Auf diese Weise wird das Kompensationsmittel räumlich auf einen Kompensationsbereich der Führungsschieneneinrichtung beschränkt.

Eine Weiterbildung der zuvor genannten Weiterbildung besteht darin, dass der Kompensationsbereich der Führungsschieneneinrichtung einen dehnbaren Abschnitt jeder Führungsschiene umfassen kann. Somit wird eine einfache Ausgestaltung des Kompensationsbereichs zur Verfügung gestellt.

Eine Weiterbildung der zur genannten Weiterbildung besteht darin, dass der dehnbare Abschnitt jeder Führungsschiene mäanderförmig ausgebildet sein kann. Dadurch kann eine einfache Ausbildung des dehnbaren Abschnitts zur Verfügung gestellt werden, worin der mäanderförmige Abschnitt aufgrund von Materialelastizität verformbar ist.

Eine Weiterbildung der zuvor genannten Weiterbildung besteht darin, dass der mäanderförmige Abschnitt der Führungsschiene alternierend angeordnete Quereinschnitte umfassen kann. Auf diese Weise kann der mäanderförmige Abschnitt auf einfach Weise realisiert werden, in dem auf beiden Seiten der Führungsschiene in wechselseitiger Anordnung Einschnitte angebracht werden.

Eine andere Weiterbildung besteht darin, dass jede Führungsschiene eine erste und eine zweite Teilführungsschiene umfassen kann, zwischen denen eine Dehnungslücke ausgebildet ist. Auf diese Weise wird eine Alternative zur mäanderförmigen Ausbildung des Kompensationsbereichs zur Verfügung gestellt.

Eine Weiterbildung der zuvor genannten Weiterbildung besteht darin, dass die erste Teilführungsschiene einen Fortsatz aufweisen kann, der bei Aufsicht auf den Führungskanal unterhalb der zweiten Teilführungsschiene relativ zu dieser bewegbar angeordnet ist. Durch den Fortsatz wird gewährleistet, dass sich in Führungskanal bewegende elektronische Bauelemente nicht in der Dehnungslücke zwischen den zwei Teilführungsschienen hängen bleiben kann.

Eine Weiterbildung der erfindungsgemäßen Führungsvorrichtung und aller deren Weiterbildungen mit Führungsschieneneinrichtung besteht darin, dass zwischen der Grundplatteneinrichtung und der Führungsschieneneinrichtung eine Abstandseinrichtung zur Anpassung des Abstands der Führungsschieneneinrichtung vom Führungskanal angeordnet sein kann. Auf diese Weise kann die Führungsvorrichtung an unterschiedliche Dicken der elektronischen Bauelemente angepasst werden.

Die Erfindung stellt auch eine Testvorrichtung für elektronische Bauelemente zur Verfügung, welche eine erfindungsgemäße Führungsvorrichtung oder eine deren Weiterbildungen umfasst. In einer erfindungsgemäßen Testvorrichtung werden Wärmedehnungen der Grundplatteneinrichtung und/oder der Führungsschieneneinrichtung kompensiert, sodass ein störungsfreies Testen gewährleistet wird.

Eine Weiterbildung der erfindungsgemäßen Testvorrichtung besteht darin, dass sie eine Beschickungsvorrichtung zum Beschicken des Führungskanals mit elektronischen Bauelemente umfassen kann. Auf diese Weise wird ein schnelles Beschicken des Führungskanals mit elektronischen Bauelemente zur Verfügung gestellt.

Eine Weiterbildung der erfindungsgemäßen Testvorrichtung und deren Weiterbildung besteht darin, dass der Führungskanal im Wesentlichen senkrecht angeordnet ist und die elektronischen Bauelemente mittels der auf sie wirkenden Schwerkraft durch den Führungskanals bewegbar sind. Auf diese Weise kann eine hohe Testrate erzielt werden.

Eine andere Weiterbildung der erfindungsgemäßen Testvorrichtung bzw. deren Weiterbildungen besteht darin, dass eine Stoppervorrichtung zum Stoppen der elektronischen Bauelemente im Führungskanal vorgesehen sein kann. Auf diese Weise können die elektronischen Bauelemente an den Temperierungsstellen einfach gestoppt werden, um die erforderlichen Tests durchzuführen.

Eine andere Weiterbildung der erfindungsgemäßen Testvorrichtung oder einer ihrer Weiterbildungen besteht darin, dass wenigstens eine Temperierungsvorrichtung für elektronischen Bauelemente vorgesehen sein kann. Damit können die elektronischen Bauelemente auf eine hohe bzw. eine niedrige Temperatur temperiert werden und deren Funktion getestet werden.

Die verschiedenen Weiterbildungen lassen sich unabhängig voneinander einsetzen bzw. geeignet miteinander kombinieren.

Weitere bevorzugte Ausführungsformen der Erfindung werden im Nachfolgenden unter Bezugnahme auf die Zeichnungen beschrieben.

### Kurzbeschreibung der Zeichnungen

- Figur 1 a, b: zeigt eine erste Ausführungsform der erfindungsgemäßen Führungsvorrichtung.
- Figur 2: zeigt eine zweite Ausführungsform der erfindungsgemäßen Führungsvorrichtung.
- Figur 3 a, b: zeigt eine dritte Ausführungsform der erfindungsgemäßen Führungsvorrichtung.
- Figur 4: zeigt eine vierte Ausführungsform der erfindungsgemäßen Führungsvorrichtung.
- Figur 5 a, b: zeigt eine Führungsschieneneinrichtung die in der erfindungsgemäßen Führungsvorrichtung eingesetzt werden kann.
- Figur 6: zeigt eine erfindungsgemäße Testvorrichtung.

### Beschreibung der Ausführungsformen

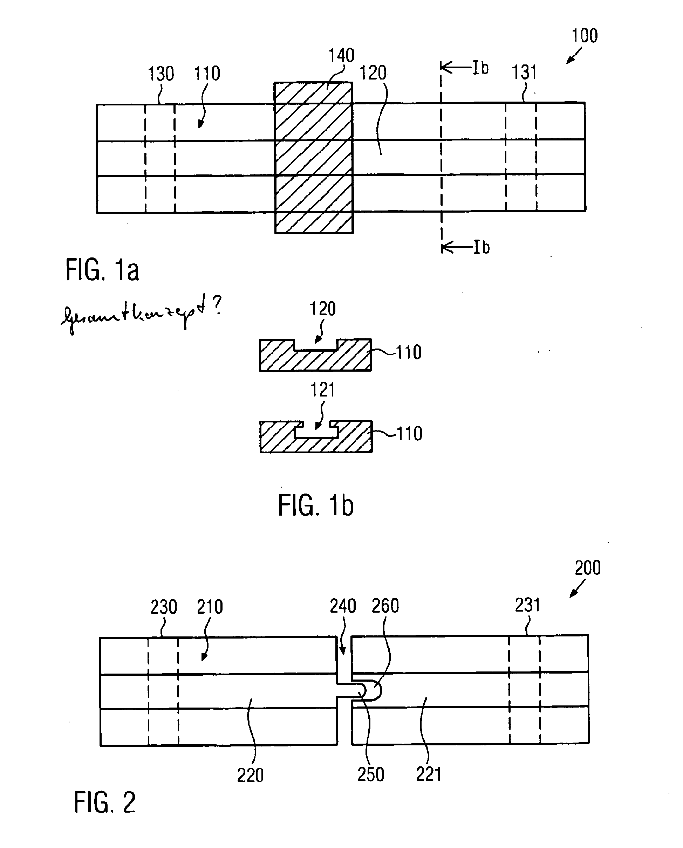

Figur 1a, b zeigt eine erste Ausführungsform der erfindungsgemäßen Führungsvorrichtung. Die Führungsvorrichtung 100 umfasst dabei eine Grundplatteneinrichtung 110 mit einem darin ausgebildeten Führungskanal 120 zur Führung von elektronischen Bauelementen. Zwei Abschnitte 130, 131 der Grundplatteneinrichtung 110 sind räumlich fixiert. Diese Abschnitte 130, 131 können in einer Testvorrichtung den Stellen entsprechen, an denen die elektronischen Bauelemente verschiedenen Temperaturen unterworfen werden. Die erfindungsgemäße Führungsvorrichtung 100 umfasst Mittel 140 zur Kompensation von Wärmedehnung der Grundplatteneinrichtung 110. Die Mittel 140 dienen dazu, Längenänderungen der Grundplatteneinrichtung aufgrund von Wärmeeinwirkung, beispielsweise an den Abschnitten 130,131, auszugleichen, sodass Spannungen vermieden werden und insbesondere der Führungskanal 120 sich nicht verbiegt.

Die beiden Teilbilder in Figur 1 b zeigen mögliche Ausgestaltungen des Führungskanals 120 und stellen eine Schnittansicht der Grundplatteneinrichtung 110 in Richtung Ib in Figur 1 a. Diese Querschnittsformen des Führungskanals 120 können in allen Ausführungsformen der Erfindung eingesetzt werden

Figur 2 zeigt eine zweite Ausführungsform der erfindungsgemäßen Führungsvorrichtung. In den Beschreibungen dieser Figur und der nachfolgenden Figuren entsprechen gleiche Bezugszeichen gleichen Elementen, wobei sich lediglich die 100er Ziffer ändert. In der zweiten Ausführungsform 200 besteht die Grundplatteneinrichtung aus einer ersten und einer zweiten Teilgrundplatte 210, 211 und die Mittel zur Kompensation von Wärmedehnung der Grundplatteneinrichtung umfassen eine Dehnungslücke 240. Die erste Teilgrundplatte 210 umfasst einen Vorsprung 250 und die zweite Teilgrundplatte umfasst eine Aussparung 260. Der Vorsprung 250 und die Aussparung 260 sind derart ausgebildet, dass der Vorsprung 250 und die Aussparung 260 in Führungskanalrichtung gegeneinander bewegbar ineinander greifen und der Vorsprung 250 die Dehnungslücke 240 zur Führung von elektronischen Bauelementen überbrückt.

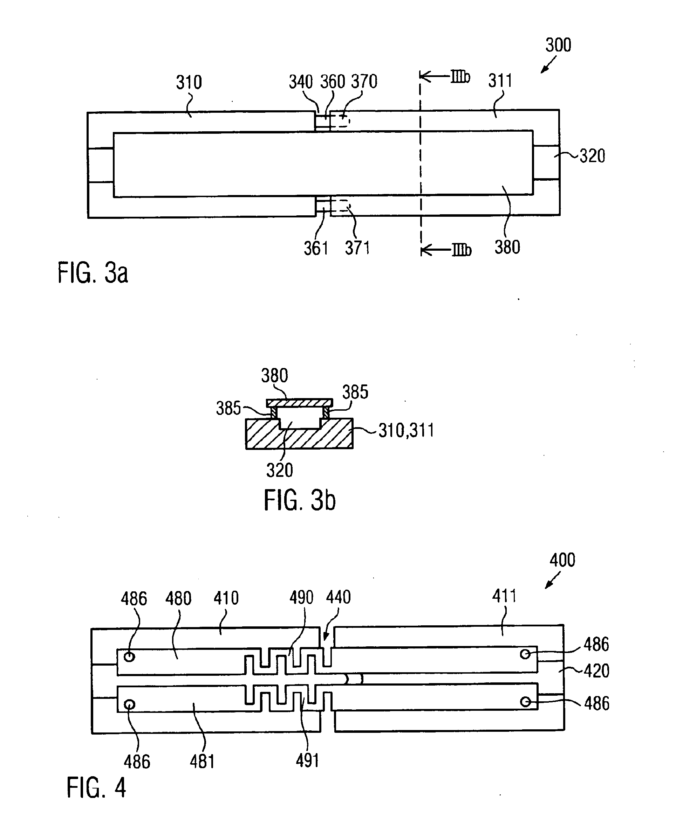

Figur 3 a, b zeigt eine dritte Ausführungsform der erfindungsgemäßen Führungsvorrichtung. Darin weist die erste Teilgrundplatte 310 Zapfen 360, 361 auf und die zweite Teilgrundplatte 311 weist Ausnehmungen 370, 371 auf. Die Zapfen 360, 361 und die Ausnehmungen 370, 371 sind derart ausgebildet, dass sich die Zapfen 360, 361 relativ zu den Ausnehmungen 370, 371 in Führungskanalrichtung bewegen können. Weiterhin weist in dieser Ausführungsform die Führungsvorrichtung eine Führungsschieneneinrichtung 380 auf, welche den Führungskanal 320 überdeckt. In Figur 3 b ist dargestellt, dass eine Abstandseinrichtung 385 vorgesehen ist, die einen Abstand der Führungsschieneneinrichtung 380 vom Führungskanal 320 zur Verfügung stellt.

Figur 4 zeigt eine vierte Ausführungsform der erfindungsgemäßen Führungsvorrichtung 400, worin der Führungskanal 420 von beiden Seiten teilweise von jeweils einer Führungsschiene 480, 481 überdeckt wird und jede Führungsschiene ist an Bereichen 486 mit der Grundplatteneinrichtung verbunden. Zur Kompensation der Wärmedehnung der Grundplatteneinrichtung und/oder der Führungsschiene 480, 481 ist darin jeweils ein dehnbaren Kompensationsbereich 490, 491 vorgesehen, welcher beispielsweise mäanderförmig ausgebildet ist. Wenn sich die Befestigungsbereiche 486 voneinander entfernen oder aufeinander zu bewegen werden die mäanderförmigen Bereiche 490, 491 gestreckt bzw. gestaucht.

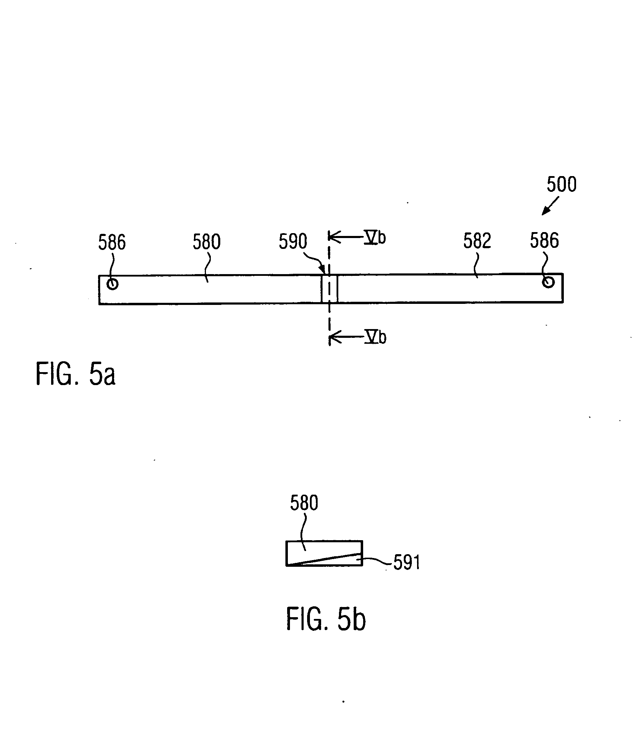

Figur 5 a, b zeigt eine alternative Ausgestaltung einer Führungsschiene 580, 582 mit Kompensationsbereich 590. Die erste Teilführungsschiene 580 weist einen Fortsatz 591 auf, der bei Aufsicht auf den Führungskanal unterhalb der zweiten Teilführungsschiene 582 relativ zu dieser bewegbar angeordnet ist. In Figur 5 b ist eine Ansicht von der Stirnseite der Teilführungsschiene 580 dargestellt. Der Fortsatz 591 weist hier beispielhaft einen dreieckigen Querschnitt auf.

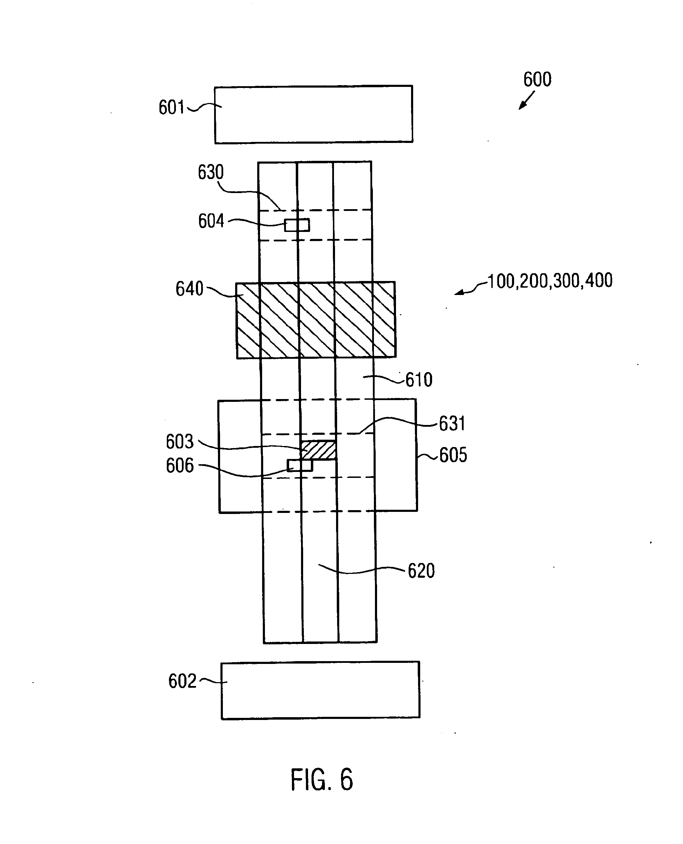

Figur 6 zeigt eine Ausführungsform einer erfindungsgemäßen Testvorrichtung 600. Diese umfasst eine erfindungsgemäße Führungsvorrichtung 100, 200, 300, 400. Weiterhin umfasst die Testvorrichtung 600 eine Beschickungsvorrichtung 601 zum Beschicken des Führungskanals 620 mit elektronischen Bauelementen. Die Führungsvorrichtung, insbesondere der Führungskanal, ist im Wesentlichen senkrecht angeordnet, sodass sich die elektronischen Bauelemente 603 aufgrund der auf sie wirkenden Schwerkraft durch den Führungskanal 620 bewegen. Am unteren Ende der Führungsvorrichtung befindet sich eine Entladevorrichtung 602, welche die getesteten elektronischen Bauelemente zum Beispiel auch sortieren kann.

Die Testvorrichtung 600 enthält Stoppervorrichtungen 604, 606 an denen beispielsweise durch seitliches Einbringen von Stiften in den Führungskanal die elektronischen Bauelemente 603 gestoppt werden können, um in den Bereichen 630, 631 getestet zu werden. Im Bereich 630 kann beispielsweise ein Test bei Umgebungstemperatur durchgeführt werden. Die Führungsvorrichtung 100, 200, 300, 400 ist dazu an dieser Stelle räumlich fixiert. Weiterhin ist eine Temperierungskammer 605 vorgesehen, sodass die elektronischen Bauelemente 603 im Bereich 631 der Führungsvorrichtung 100, 200, 300, 400 bei anderen Temperaturen als der Umgebungstemperatur getestet werden können. Beispielsweise können durch Zuführen von kaltem Stickstoffgas die elektronischen Bauelemente 603 abgekühlt werden, oder sie können durch Zuführen von heißer Luft auf hohe Temperaturen gebracht werden.

Die Temperierung der elektronischen Bauelemente 603 hat zu Folge, dass auch die Führungsvorrichtung 100, 200, 300, 400 diesen Temperaturen ausgesetzt ist und sich demzufolge dehnt bzw. zusammenzieht. Die auftretenden Dehnungen werden durch die Mittel 640 zur Kompensation von Wärmedehnung der Grundplatteneinrichtung 610 kompensiert, sodass keine Spannungen auftreten.

## Patentansprüche

1. Führungsvorrichtung (100; 200; 300; 400), umfassend:
eine Grundplatteneinrichtung (110; 210, 211; 310, 311; 410, 411; 610) mit einem darin ausgebildeten Führungskanal (120; 220; 320; 420; 620) zur Führung von elektronischen Bauelementen (603);
worin wenigstens zwei Abschnitte (130, 131; 230, 231; 63, 631) der Grundplatteneinrichtung (110; 210, 211; 310, 311; 410, 411; 610) räumlich fixiert sind;
**dadurch gekennzeichnet, dass**
Mittel (140; 240; 340; 440; 640) zur Kompensation von Wärmedehnung der Grundplatteneinrichtung (110; 210, 211; 310, 311; 410, 411; 610) vorgesehen sind.

2. Führungsvorrichtung nach Anspruch 1, worin die Mittel zur Kompensation von Wärmedehnung der Grundplatteneinrichtung einen Kompensationsbereich (240; 340; 440) der Grundplatteneinrichtung zwischen den wenigstens zwei räumlich fixierten Abschnitten umfassen.

3. Führungsvorrichtung nach Anspruch 2, worin die Grundplatteneinrichtung in Führungskanalrichtung eine erste (210; 310; 410) und eine zweite Teilgrundplatte (211; 311; 411) umfasst, zwischen denen im Kompensationsbereich der Grundplatteneinrichtung eine Dehnungslücke (240; 340; 440) ausgebildet ist.

4. Führungsvorrichtung nach Anspruch 3, worin die erste Teilgrundplatte einen Vorsprung (250) und die zweite Teilgrundplatte eine Aussparung (260) aufweist, derart ausgebildet, dass der Vorsprung und die Aussparung in Führungskanalrichtung gegeneinander bewegbar ineinander greifen und der Vorsprung die Dehnungslücke zur Führung der elektronischen Bauelemente überbrückt.

5. Führungsvorrichtung nach Anspruch 3 oder 4, worin eine der Teilgrundplatten einen Zapfen (360, 361) und die andere Teilgrundplatte eine Ausnehmung (370, 371) zur Aufnahme des Zapfens umfasst, worin der Zapfen und die Ausnehmung in einem Querschnitt senkrecht zur Führungskanalrichtung komplementär zueinander ausgebildet sind und der Zapfen relativ zu der Ausnehmung in Führungskanalrichtung bewegbar ist.

6. Führungsvorrichtung nach einem der vorhergehenden Ansprüche, worin eine Führungsschieneneinrichtung (380; 480, 481; 580, 582) entlang des Führungskanals zur wenigstens teilweisen Überdeckung des Führungskanals vorgesehen ist.

7. Führungsvorrichtung nach Anspruch 6, worin Abschnitte (486) der Führungsschieneneinrichtung, vorzugsweise in Führungskanalrichtung gelegene Endabschnitte der Führungsschieneneinrichtung, räumlich fixiert sind und Mittel zur Kompensation von Wärmedehnung der Führungsschieneneinrichtung vorgesehen sind.

8. Führungsvorrichtung nach Anspruch 6, worin wenigstens zwei Bereiche der Führungsschieneneinrichtung mit der Grundplatteneinrichtung verbunden sind und die Führungseinrichtung Mittel (490, 491; 590, 591) zur Kompensation von Wärmedehnung der Grundplatteneinrichtung und/oder zur Kompensation von Wärmedehnung der Führungsschieneneinrichtung umfasst.

9. Führungsvorrichtung nach Anspruch 6 bis 8, worin die Führungsschieneneinrichtung wenigstens eine Führungsschiene umfasst, und wenigstens zwei Bereiche (486) der / jeder Führungsschiene mit der Grundplatteneinrichtung verbunden sind.

10. Führungsvorrichtung nach Anspruch 6 bis 9, worin die Führungsschieneneinrichtung eine erste (480) und eine zweite (481) Führungsschiene umfasst, die jeweils derart entlang des Führungskanals angeordnet sind, dass der Führungskanal im Querschnitt beidseitig wenigstens teilweise überdeckt ist.

11. Führungsvorrichtung nach Anspruch 7 bis 10, worin die Mittel zur Kompensation von Wärmedehnung der wenigstens einen Führungsschiene und/oder zur Kompensation von Wärmedehnung der Grundplatteneinrichtung einen Kompensationsbereich (490, 491; 590) der Führungsschieneneinrichtung umfassen.

12. Führungsvorrichtung nach Anspruch 11, worin der Kompensationsbereich der Führungsschieneneinrichtung einen dehnbaren Abschnitt (490, 491) jeder Führungsschiene umfasst.

13. Führungsvorrichtung nach Anspruch 12, worin der dehnbare Abschnitt jeder Führungsschiene mäanderförmig ausgebildet ist.

14. Führungsvorrichtung nach Anspruch 13, worin der mäanderfömige Abschnitt jeder Führungsschiene alternierend angeordnete Quereinschnitte umfasst.

15. Führungsvorrichtung nach Anspruch 10, worin jede Führungsschiene eine erste (580) und eine zweite (582) Teilführungsschiene umfasst zwischen denen eine Dehnungslücke (590) ausgebildet ist.

16. Führungsvorrichtung nach Anspruch 15, worin die erste Teilführungsschiene einen Fortsatz (591) aufweist, der bei Aufsicht auf den Führungskanal unterhalb der zweiten Teilführungsschiene relativ zu dieser bewegbar angeordnet ist.

17. Führungsvorrichtung nach einem der Ansprüche 6 bis 16, worin zwischen der Grundplatteneinrichtung und der Führungsschieneneinrichtung eine Abstandseinrichtung (385) zur Anpassung des Abstands der Führungsschieneneinrichtung vom Führungskanal angeordnet ist.

18. Testvorrichtung (600) für elektronische Bauelemente (603), umfassend:
eine Führungsvorrichtung (100; 200; 300; 400) nach einem der Ansprüche 1 bis 17.

19. Testvorrichtung nach Anspruch 18, weiterhin umfassend:
eine Beschickungsvorrichtung (601) zum Beschicken des Führungskanals (620) mit den elektronischen Bauelementen.

20. Testvorrichtung nach Anspruch 18 oder 19, worin der Führungskanal im Wesentlichen senkrecht angeordnet ist und die elektronischen Bauelemente mittels der auf sie wirkenden Schwerkraft durch den Führungskanal bewegbar sind.

21. Testvorrichtung nach einem der Ansprüche 18 bis 20, weiterhin umfassend:
eine Stoppervorrichtung (604, 606) zum Stoppen der elektronischen Bauelemente im Führungskanal.

22. Testvorrichtung nach einem der Ansprüche 18 bis 21, weiterhin umfassend:
wenigstens eine Temperierungsvorrichtung (605) für elektronische Bauelemente.

## Claims

1. A guide device (100, 200, 300, 400), comprising:
a baseplate unit (110; 210; 211; 310; 311; 410; 411; 610) having formed therein a guide channel (120; 220; 320; 420; 620) for guiding electronic devices (603);
wherein at least two portions (130, 131; 230; 231; 630; 631) of the baseplate unit (110; 210; 211; 310; 311; 410; 411; 610) are spatially fixed;
**characterized in that**
means (140; 240; 340; 440; 640) are provided for compensating the thermal expansion of the baseplate unit (110; 210; 211; 310; 311; 410; 411; 610).

2. A guide device according to claim 1, wherein said means for compensating the thermal expansion of the baseplate unit comprise a compensating region (240; 340; 440) of the baseplate unit between said at least two spatially fixed portions.

3. A guide device according to claim 2, wherein the baseplate unit comprises a first (210; 310; 410) and a second (211; 311; 311) sub-baseplate in the direction of the guide channel, said sub-baseplates having formed between them an expansion gap (240; 340; 440) in the compensating region of the baseplate unit.

4. A guide device according to claim 3, wherein the first sub-baseplate comprises a projection (250) and the second sub-baseplate comprises a recess (260), said projection and said recess being so implemented that they interengage in such a way that they are movable relative to one another in the direction of the guide channel, and that the projection bridges the expansion gap so as to guide the electronic devices.

5. A guide device according to claim 3 or 4, wherein one of the sub-baseplates (360, 361) comprises a pin (360, 361) and the other sub-baseplate comprises a recess (370, 371) for accommodating the pin, said pin and said recess being implemented complementarily to one another, when seen in a cross-sectional view at right angles to the direction of the guide channel, and said pin being movable relative to said recess in the direction of the guide channel.

6. A guide device according to one of the preceding claims, wherein a guiderail means (380; 480; 481; 580; 582) is provided along the guide channel so as to cover said guide channel at least partially.

7. A guide device according to claim 6, wherein portions (486) of the guiderail means, preferably end portions of the guiderail means which are positioned in the direction of the guide channel, are spatially fixed, and wherein means for compensating the thermal expansion of the guiderail means are provided.

8. A guide device according to claim 6, wherein at least two areas of the guiderail means are connected to the baseplate unit, and wherein the guiderail means comprises means (490, 491; 590, 591) for compensating the thermal expansion of the baseplate unit and/or for compensating the thermal expansion of the guiderail means.

9. A guide device according to claims 6 to 8, wherein the guiderail means comprises at least one guiderail, and wherein at least two areas (486) of the / of each guiderail are connected to the baseplate unit.

10. A guide device according to claims 6 to 9, wherein the guiderail means comprises a first (480) and a second (481) guiderail, each of said guiderails being arranged along the guide channel in such a way that, when seen in a cross-sectional view, the guide channel is covered at least partially on both sides.

11. A guide device according to claim 7 to 10, wherein the means for compensating the thermal expansion of the at least one guiderail and/or for compensating the thermal expansion of the baseplate unit comprise a compensating region (490, 491; 590) of the guiderail means.

12. A guide device according to claim 11, wherein the compensating region of the guiderail means comprises an expandable portion (490, 491) of each guiderail.

13. A guide device according to claim 12, wherein the expandable portion of each guiderail is meandrous in shape.

14. A guide device according to claim 13, wherein the meandrous portion of each guiderail comprises alternating transverse indentations.

15. A guide device according to claim 10, wherein each guiderail comprises a first (580) and a second (582) sub-guiderail, said sub-guiderails having an expansion gap (590) formed between them.

16. A guide device according to claim 15, wherein said first sub-guiderail is provided with an extension (591) which, when the guide channel is seen from above, is arranged below the second sub-guiderail such that it is movable relative thereto.

17. A guide device according to one of the claims 6 to 16, wherein the baseplate unit and the guide rail means have arranged between them a spacer (385) for adapting the distance of the guide rail means from the guide channel.

18. A test apparatus (600) for electronic devices (603), comprising:
a guide device (100; 200; 300; 400) according to one of the claims 1 to 17.

19. A test apparatus according to claim 18, further comprising:
a feeder (601) for charging the guide channel (620) with electronic devices.

20. A test apparatus according to claim 18 or 19, wherein the guide channel is arranged in an essentially upright position and the electronic devices are adapted to be moved through the guide channel by means of the force of gravity acting thereon.

21. A test apparatus according to one of the claims 18 to 20, further comprising:
a stopper (604, 606) for stopping the electronic devices in the guide channel.

22. A test apparatus according to one of the claims 18 to 21, further comprising:
at least one temperature adjustment unit (605) for electronic devices.

## Revendications

1. Dispositif de guidage (100 ; 200 ; 300 ; 900), comprenant :
un agencement de platine de base (110 ; 210, 211 ; 310, 311 ; 410, 411 ; 610) avec un canal de guidage (120 ; 220 ; 320 ; 420 ; 620) réalisé dans celui-ci pour guider des composants électroniques (603) ;
dans lequel au moins deux portions (130, 131 ; 230, 231 ; 63, 631) de l'agencement de platine de base (110 ; 210, 211 ; 310, 311 ; 410, 411 ; 610) sont fixées dans l'espace ;
**caractérisé en ce que**
des moyens (140 ; 240 ; 340 ; 440 ; 640) pour compenser une dilatation thermique de l'agencement de platine de base (110 ; 210, 211 ; 310, 311 ; 410, 411 ; 610) sont prévus.

2. Dispositif de guidage selon la revendication 1, dans lequel les moyens pour compenser une dilatation thermique de l'agencement de platine de base comprennent une zone de compensation (240 ; 340 ; 440) de l'agencement de platine de base entre les au moins deux portions fixées dans l'espace.

3. Dispositif de guidage selon la revendication 2, dans lequel l'agencement de platine de base comprend dans la direction du canal de guidage une première (210 ; 310 ; 410) et une deuxième platine de base partielle (211 ; 311 ; 411), entre lesquelles dans la zone de compensation de l'agencement de platine de base un espace de dilatation (240 ; 340 ; 440) est réalisé.

4. Dispositif de guidage selon la revendication 3, dans lequel la première platine de base partielle présente une saillie (250) et la deuxième platine de base partielle un évidement (260), réalisés de telle sorte que la saillie et l'évidement s'engagent l'un dans l'autre de façon mobile dans la direction du canal de guidage et la saillie comble l'espace de dilatation pour guider les composants électroniques.

5. Dispositif de guidage selon la revendication 3 ou 4, dans lequel l'une des platines de base partielles comprend un tenon (360, 361) et l'autre platine de base partielle comprend un creux (370, 371) pour recevoir le tenon, dans lequel le tenon et le creux sont réalisés de façon complémentaire l'un à l'autre dans une section transversale perpendiculaire à la direction du canal de guidage et le tenon est mobile par rapport au creux dans la direction du canal de guidage.

6. Dispositif de guidage selon l'une quelconque des revendications précédentes, dans lequel un agencement de rail de guidage (380 ; 480, 481 ; 580, 582) est prévu le long du canal de guidage pour recouvrir au moins en partie le canal de guidage.

7. Dispositif de guidage selon la revendication 6, dans lequel certaines portions (486) de l'agencement de rail de guidage, de préférence des portions terminales de l'agencement de rail de guidage situées dans la direction du canal de guidage sont fixées dans l'espace et des moyens pour compenser une dilatation thermique de l'agencement de rail de guidage sont prévus.

8. Dispositif de guidage selon la revendication 6, dans lequel au moins deux zones de l'agencement de rail de guidage sont reliées à l'agencement de platine de base et le dispositif de guidage comprend des moyens (490, 491 ; 590, 591) pour compenser une dilatation thermique de l'agencement de platine de base et/ou pour compenser une dilatation thermique de l'agencement de rail de guidage.

9. Dispositif de guidage selon les revendications 6 à 8, dans lequel l'agencement de rail de guidage comprend au moins un rail de guidage, et au moins deux zones (486) dudit/de chaque rail de guidage sont reliées à l'agencement de platine de base.

10. Dispositif de guidage selon les revendications 6 à 9, dans lequel l'agencement de rail de guidage comprend un premier (480) et un deuxième (481) rail de guidage qui sont disposés respectivement le long du canal de guidage de telle sorte que le canal de guidage est recouvert au moins en partie des deux côtés en section transversale.

11. Dispositif de guidage selon les revendications 7 à 10, dans lequel les moyens pour compenser une dilatation thermique du au moins un rail de guidage et/ou pour compenser une dilatation thermique de l'agencement de platine de base comprennent une zone de compensation (490, 491 ; 590) de l'agencement de rail de guidage.

12. Dispositif de guidage selon la revendication 11, dans lequel la zone de compensation de l'agencement de rail de guidage comprend une portion extensible (490, 491) de chaque rail de guidage.

13. Dispositif de guidage selon la revendication 12, dans lequel la portion extensible de chaque rail de guidage est réalisée en forme de méandre.

14. Dispositif de guidage selon la revendication 13, dans lequel la portion en forme de méandre de chaque rail de guidage comprend des encoches transversales disposées en alternance.

15. Dispositif de guidage selon la revendication 10, dans lequel chaque rail de guidage comprend un premier (580) et un deuxième (582) rail de guidage partiel entre lesquels un espace de dilatation (590) est réalisé.

16. Dispositif de guidage selon la revendication 15, dans lequel le premier rail de guidage partiel présente un prolongement (591) qui, en vue de dessus du canal de guidage, est disposé au-dessous du deuxième rail de guidage partiel de façon mobile par rapport à celui-ci.

17. Dispositif de guidage selon l'une quelconque des revendications 6 à 16, dans lequel entre l'agencement de platine de base et l'agencement de rail de guidage un agencement d'écartement (385) est disposé pour adapter l'espacement de l'agencement de rail de guidage par rapport au canal de guidage.

18. Dispositif d'essai (600) pour composants électroniques (603), comprenant :
un dispositif de guidage (100 ; 200 ; 300 ; 400) selon l'une quelconque des revendications 1 à 17.

19. Dispositif d'essai selon la revendication 18, comprenant en outré :
un dispositif d'alimentation (601) pour alimenter le canal de guidage (620) en composants électroniques.

20. Dispositif d'essai selon la revendication 18 ou 19, dans lequel le canal de guidage est disposé de façon substantiellement verticale et les composants électroniques peuvent être déplacés à travers le canal de guidage sous l'effet de la force de gravité agissant sur ceux-ci.

21. Dispositif d'essai selon l'une quelconque des revendications 18 à 20, comprenant en outre :
un dispositif d'arrêt (604, 606) pour arrêter les composants électroniques dans le canal de guidage.

22. Dispositif d'essai selon l'une quelconque des revendications 18 à 21, comprenant en outré :
au moins un dispositif d'équilibrage de température (605) pour composants électroniques.
